# EUROPEAN PATENT APPLICATION

(11) **EP 3 264 585 A1**
(43) Date of publication of application: **03.01.2018**
(21) Application number: 16754996.3
(22) Date of filing: 23.02.2016
(51) Int. Cl.: H02N 11/00, H01L 35/28, H01L 35/30

(54) **POWER GENERATION SYSTEM**

(30) Priority: 25.02.2015 JP 2015035540
(71) Applicant: Chiyoda Corporation, Kanagawa 220-8765 (JP)
(72) Inventor: MATSUDA, Kazuo, Yokohama-shi Kanagawa 220-8765 (JP); MATSUMOTO, Tadashi, Yokohama-shi Kanagawa 220-8765 (JP); HIRAI, Toshihide, Yokohama-shi Kanagawa 220-8765 (JP); TANAKA, Satoshi, Yokohama-shi Kanagawa 220-8765 (JP)
(74) Representative: Piésold, Alexander James
(86) International application number: PCT/JP2016/000962
(87) International publication number: WO 2016/136246

(57) **Abstract**

A power generation system that has an increased power generation efficiency and can be substituted for a conventional heat exchanging system is provided. A power generation system 1 comprises a power generation module 2 provided with one or more thermoelectric elements 7A, 7B; a heat exchanger 3; a high-temperature fluid passage 4 including a high-temperature fluid inlet 4A and a high-temperature fluid outlet 4B, the high-temperature fluid passage being connected to the power generation module and the heat exchanger both located between the high-temperature fluid inlet and the high-temperature fluid outlet; and a low-temperature fluid passage 5 including a low-temperature fluid inlet 5A and a low-temperature fluid outlet 5B, the low-temperature fluid passage being connected to the power generation module and the heat exchanger both located between the low-temperature fluid inlet and the low-temperature fluid outlet. The low-temperature fluid passage includes a low-temperature-side bypass passage 5F for bypassing the power generation module, and a low-temperature-side flow rate adjusting valve 50 for adjusting a flow rate of the low-temperature fluid flowing into the power generation module, and a degree of opening of the low-temperature-side flow rate adjusting valve is controlled based on a temperature difference between the high-temperature fluid and the low-temperature fluid immediate after flowing out of the high-temperature fluid outlet and the low-temperature fluid outlet.

## Description

### TECHNICAL FIELD

The present invention relates to a power generation system for generating electric power with a thermoelectric element utilizing a temperature difference between supplied high-and low-temperature fluids and for adjusting at least one of the high- and low-temperature fluids to a prescribed temperature before discharging it out of the system.

### BACKGROUND ART

Known power generation systems include a system using thermoelectric elements to convert thermal energy into electric energy by the Seebeck effect (as shown in Patent Document 1, for example). Patent Document 1 discloses that a system includes thermoelectric elements interposed between a pair of thermally conductive plates to thereby form plate-like power generating units, and that a plurality of the plate-like power generating units are laminated to form high- and low-temperature passages between adjoining pairs of the plate-like power generating units which passages allow high- and low-temperature fluids to flow, respectively. The power generation system is incorporated into a power generating plant and utilizes water vapor that has passed through a steam turbine as the high-temperature fluid. This type of power generation system utilizes waste heat in the plant in generating power, and thus can help improve energy efficiency of the whole plant.

### PRIOR ART DOCUMENT(S)

### PATENT DOCUMENT(S)

Patent Document 1: JP2009-081970A

### SUMMARY OF THE INVENTION

### TASK TO BE ACCOMPLISHED BY THE INVENTION

Since each thermoelectric element generates only a low electromotive force, a large number of thermoelectric elements are generally used in series connection. However, the larger the number of thermoelectric elements is, the larger the amount of heat exchange between the high-temperature fluid and the low-temperature fluid flowing in the power generation system, which results in decreased temperature differences between both sides of some thermoelectric elements. The electromotive force generated by a thermoelectric element changes depending on a temperature difference between both sides of the thermoelectric element. Thus, when a power generation system operates in a state where temperature differences between both sides of the thermoelectric elements are relatively small, the power generation efficiency per element decreases, resulting in an increase in the cost of the power generation system in terms of a power generation amount. Thus, from a perspective of efficiency of electric power generation, it is preferable to configure a power generation system to include a decreased number of thermoelectric elements, thereby reducing the amount of heat exchange between the high- and low-temperature fluids to maintain higher temperature differences between both sides of the respective thermoelectric elements. However, in this case, only a small amount of heat is exchanged between the high- and low-temperature fluids when the fluids flow between thermoelectric elements. Thus, it becomes difficult to cool the discharged high-temperature fluid or to heat the discharged low-temperature fluid; that is, it becomes difficult to adequately adjust the temperatures of the discharged fluids.

The present invention has been made in view of the aforementioned problems of the prior art, and a primary object of the present invention is to provide a power generation system having an increased power generation efficiency per each thermoelectric element and capable of adjusting the temperature of high- or low-temperature fluid to be discharged out of the system.

### MEANS TO ACCOMPLISH THE TASK

In order to attain the above object, one aspect of the present invention provides a power generation system (1) comprising a power generation module (2) provided with one or more thermoelectric elements (7A, 7B); a heat exchanger (3); a high-temperature fluid passage (4) including a high-temperature fluid inlet (4A) and a high-temperature fluid outlet (4B), the high-temperature fluid passage being connected to the power generation module and the heat exchanger both located between the high-temperature fluid inlet and the high-temperature fluid outlet; and a low-temperature fluid passage (5) including a low-temperature fluid inlet (5A) and a low-temperature fluid outlet (5B), the low-temperature fluid passage being connected to the power generation module and the heat exchanger both located between the low-temperature fluid inlet and the low-temperature fluid outlet, wherein the low-temperature fluid passage includes a low-temperature-side bypass passage (5F) for bypassing the power generation module, and a low-temperature-side flow rate adjusting valve (50) for adjusting a flow rate of the low-temperature fluid flowing into the power generation module, and a degree of opening of the low-temperature-side flow rate adjusting valve is controlled based on a temperature difference between the high-temperature fluid and the low-temperature fluid immediate after flowing out of the high-temperature fluid outlet and the low-temperature fluid outlet.

According to this aspect of the present invention, even when the system is used under the condition that less heat is exchanged in order to maintain the temperature difference between the high-temperature fluid and the low-temperature fluid in the power generation modules, the system is allowed to use the heat exchanger provided downstream of the power generation module to cool the high-temperature fluid or to heat the low-temperature fluid before discharging it out of the system. This means that even when the system is used under the condition that the temperature difference between the high-temperature fluid and the low-temperature fluid in the power generation modules is maintained rather high so as to improve the power generation efficiency per element, the system is allowed to adjust the temperature of the high-temperature fluid or heat the low-temperature fluid by the heat exchanger before discharging it out of the system. Accordingly, the power generation system can be applied to a part of various plants where cooling or heating fluid is required, and thus can be substituted for a conventional heat exchanging system. Also, the power generation system of the present invention can be constructed by adding the power generation module at a location upstream of a conventional heat exchanging system. This means that the system of the present invention can be easily applied to an existing facility. In addition, in the power generation system, the power generation module and the heat exchanger use the common high- and low-temperature fluids, thereby enabling the system to be simple. Moreover, since the high- and low-temperature fluids are supplied to the power generation module before being supplied to the heat exchanger, the system is allowed to increase the temperature difference between the high-and low-temperature fluids in the power generation module. Furthermore, even when changes occur in the temperatures and flow rates of the high-temperature fluid and the low-temperature fluid, the system is allowed to adjust the flow rate of the low-temperature fluid supplied to the power generation module to maintain the temperature difference between the high-temperature fluid and the low-temperature fluid at the outlets of the power generation module to a prescribed level or more.

The above-described system of the present invention may further include a high-temperature-side bypass passage (4F) for bypassing the power generation module, and a high-temperature-side flow rate adjusting valve (55) for adjusting a flow rate of the high-temperature fluid flowing into the power generation module, wherein a degree of opening of the high-temperature-side flow rate adjusting valve is controlled based on the temperature difference between the high-temperature fluid and the low-temperature fluid immediate after flowing out of the power generation module.

In this case, even when changes occur in the temperatures and flow rates of the high-and low-temperature fluids, the system is allowed to adjust the flow rate of the high-temperature fluid supplied to the power generation module to maintain the temperature difference between the high-temperature fluid and the low-temperature fluid at the outlets of the power generation module to a prescribed level or more.

Another aspect of the present invention provides a power generation system (1) comprising a power generation module (2) provided with one or more thermoelectric elements (7A, 7B); a heat exchanger (3); a high-temperature fluid passage (4) including a high-temperature fluid inlet (4A) and a high-temperature fluid outlet (4B), the high-temperature fluid passage being connected to the power generation module and the heat exchanger both located between the high-temperature fluid inlet and the high-temperature fluid outlet; and a low-temperature fluid passage (5) including a low-temperature fluid inlet (5A) and a low-temperature fluid outlet (5B), the low-temperature fluid passage being connected to the power generation module and the heat exchanger both located between the low-temperature fluid inlet and the low-temperature fluid outlet, wherein the high-temperature fluid passage includes a high-temperature-side bypass passage (4F) for bypassing the power generation module, and a high-temperature-side flow rate adjusting valve (55) for adjusting a flow rate of the high-temperature fluid flowing into the power generation module, and a degree of opening of the high-temperature-side flow rate adjusting valve is controlled based on a temperature difference between the high-temperature fluid and the low-temperature fluid immediate after flowing out of the high-temperature fluid outlet and the low-temperature fluid outlet.

In this aspect of the present invention, the high-temperature-side bypass passage (4G) may bypass the power generation module and the heat exchanger.

In this case, when the temperature of the high-temperature fluid is low, the system is allowed to discharge the high-temperature fluid out of the system without causing the fluid to flow through the power generation module and the heat exchanger.

In the above-described aspect, the system preferably comprise a temperature controller (141, 151) provided between the high-temperature fluid inlet and the power generation module for controlling a temperature of the high-temperature fluid.

In this case, the system is allowed to adjust the temperature of the high-temperature fluid to be supplied to the power generation module. This means that the system can prevent the high-temperature fluid having an excessively high temperature from being supplied to the power generation module, thereby preventing heat damage to the thermoelectric elements.

Preferably, the above-described system of the present invention includes the temperature controller (151) which is connected to a branch passage branched from the low-temperature fluid passage and controls the temperature of the high-temperature fluid by mixing the low-temperature fluid supplied from the branch passage and the high-temperature fluid.

In this case, the system can decrease the temperature of the high-temperature fluid in an efficient manner. For example, the system so configured is suitable for cases where the high-temperature fluid and the low-temperature fluid can be mixed, for example cases where the high-temperature fluid and the low -temperature fluid are the same fluid (e.g. an aqueous solution such as water).

The above-described system of the present invention preferably includes the temperature controller (141) which is connected to a branch passage branched from the low-temperature fluid passage and controls the temperature of the high-temperature fluid by exchanging heat between the low-temperature fluid supplied from the branch passage and the high-temperature fluid without mixing the low-temperature fluid and the high-temperature fluid.

In this case, the system can decrease the temperature of the high-temperature fluid while avoiding mixing of the high-temperature fluid and the low-temperature fluid. For example, the system so configured is suitable for cases where the high-temperature fluid is an organic solution such as hydrocarbon and the low-temperature fluid is an aqueous solution such as water.

Preferably, in the above-described system of the present invention, the temperature of the low-temperature fluid is 60-degrees Celsius or lower at the low-temperature fluid outlet.

In this case, the system can prevent an undesirable rise in the temperature of the fluid in the low-temperature fluid passage, thereby minimizing clogging of the low-temperature fluid passage due to the growth of algae or the like.

Preferably, in the above-described system of the present invention, the power generation module is configured such that the high-temperature fluid and the low-temperature fluid flow in opposite directions along opposite sides of each thermoelectric element.

In this case, the system is allowed to unify the distribution of the temperature differences between the high-temperature fluid and the low-temperature fluid over the power generation module, thereby improving the efficiency of power generation by the thermoelectric elements.

### EFFECT OF THE INVENTION

As can be appreciated from the foregoing, the present invention can provide a power generation system which can realize increased power generation efficiency and can be substituted for a conventional heat exchanging system.

### BRIEF DESCRIPTION OF THE DRAWINGS

Figure 1 is a block diagram showing a power generation system in accordance with a first embodiment of the present invention;
Figure 2 is an exploded perspective view of the power generation system of the first embodiment of the present invention;
Figure 3 is an exploded perspective view of a plate unit of the system of the first embodiment of the present invention;
Figure 4 is a cross-sectional view of the power generation system of the first embodiment of the present invention;
Figure 5(A) is a block diagram and Figure 5(B) is a graphic representation showing temperature changes in the power generation system of the first embodiment of the present invention;
Figure 6(A) is a block diagram and Figure 6(B) is a graphic representation showing temperature changes in a power generation system of a comparative embodiment;
Figure 7 is a block diagram showing a power generation system in accordance with a second embodiment of the present invention;
Figure 8 is a block diagram showing a power generation system in accordance with a third embodiment of the present invention;
Figure 9 is a block diagram showing a power generation system in accordance with a fourth embodiment of the present invention;
Figure 10 is a block diagram showing a power generation system in accordance with a fifth embodiment of the present invention;
Figure 11 is a block diagram showing a power generation system in accordance with a sixth embodiment of the present invention;
Figure 12 is a block diagram showing a power generation system in accordance with a seventh embodiment of the present invention;
Figure 13 is a block diagram showing an example in which a power generation system of one embodiment of the present invention is applied to a petroleum refining plant;
Figure 14 is a block diagram showing an example in which a power generation system of one embodiment of the present invention is applied to a power generating plant;

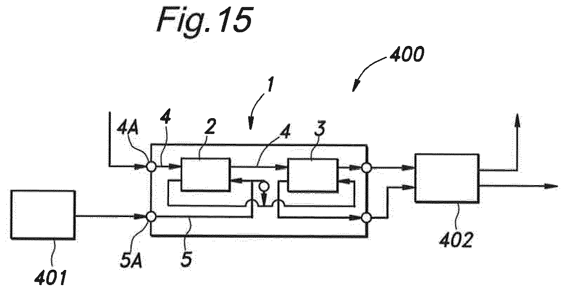

Figure 15 is a block diagram showing an example in which a power generation system of one embodiment of the present invention is applied to an LNG regasification facility;
Figure 16 is a block diagram showing an example in which a power generation system of one embodiment of the present invention is applied to a reaction facility; and
Figure 17 is a block diagram showing an example in which a power generation system of one embodiment of the present invention is applied to a dehydrogenation reaction facility for hydrogenated aromatic compound.

### DESCRIPTION OF THE PREFERRED EMBODIMENT(S)

Power generation systems in accordance with preferred embodiments of the present invention are described in the following with reference to the appended drawings.

### (First Embodiment)

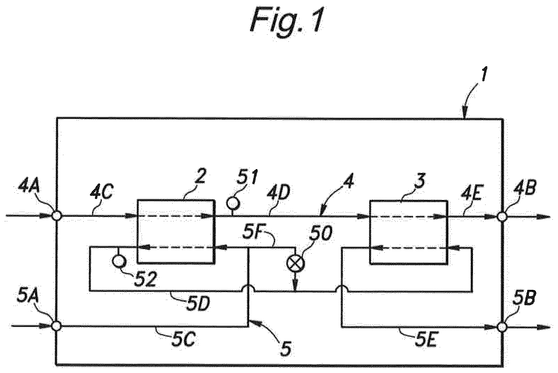

As shown in Figure. 1, the power generation system 1 includes a power generation module 2, a heat exchanger 3, a high-temperature fluid passage 4, and a low-temperature fluid passage 5 connected to the power generation module 2 and to the heat exchanger 3. The high-temperature fluid passage 4 includes a high-temperature fluid inlet 4A serving as an inlet for a high-temperature fluid to the power generation system 1 and a high-temperature fluid outlet 4B serving as a high-temperature fluid outlet from the power generation system 1, and is connected to the power generation module 2 and the heat exchanger 3 both located between the high-temperature fluid inlet 4A and the high-temperature fluid outlet 4B. The low-temperature fluid passage 5 includes a low-temperature fluid inlet 5A serving as an inlet for low-temperature fluid to the power generation system 1 and a low-temperature fluid outlet 5B serving as an outlet of low-temperature fluid from the power generation system 1, and is connected to the power generation module 2 and the heat exchanger 3 both located between the low-temperature fluid inlet 5A and the low-temperature fluid outlets 5B.

In the present embodiment, the high-temperature fluid passage 4 includes a passage 4C connecting the high-temperature fluid inlet 4A and the power generation module 2, a passage 4D connecting the power generation module 2 and the heat exchanger 3, and a passage 4E connecting the heat exchanger 3 and the high-temperature fluid outlet 4B. Thus, the high-temperature fluid passage 4 connects the power generation module 2 and the heat exchanger 3 in series, and the high-temperature fluid flows in the order of the power generation module 2 and the heat exchanger 3.

In the present embodiment, the low-temperature fluid passage 5 includes a passage 5C connecting the low-temperature fluid inlet 5A and the power generation module 2, a passage 5D connecting the power generation module 2 and the heat exchanger 3, and a passage 5E connecting the heat exchanger 3 and the low-temperature fluid outlet 5B. Thus, the low-temperature fluid passage 5 connects the power generation module 2 and the heat exchanger 3 in series, and the low-temperature fluid flows in the order of the power generation module 2 and the heat exchanger 3. In addition, the low-temperature fluid passage 5 includes a bypass passage 5F connected to the passages 5C and 5D to bypass the power generation module 2.

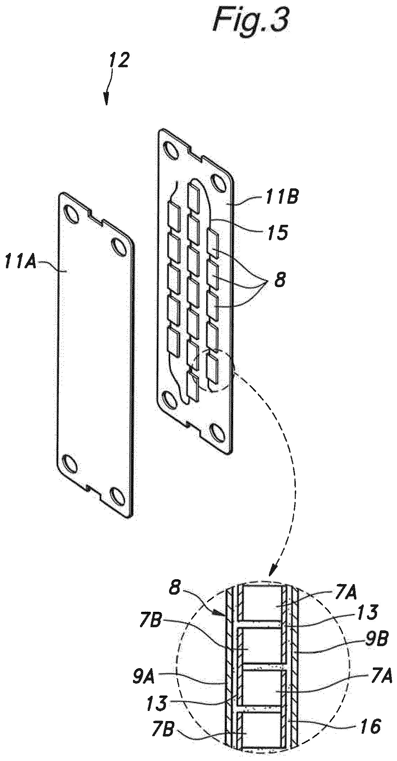

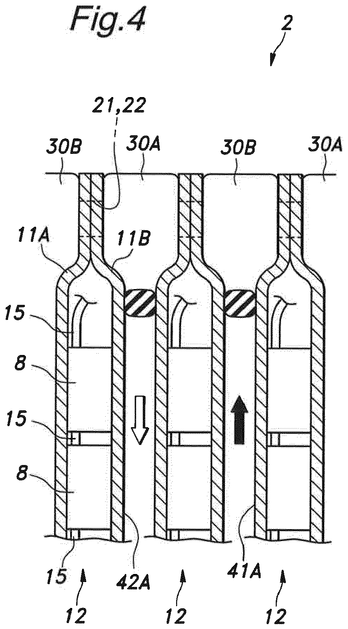

As shown in Figures 3 and 4, the power generation module 2 includes thermoelectric elements 7A, 7B, which convert thermal energy into electric energy by the Seebeck effect. In the present embodiment, each thermoelectric element 7A is formed of a p-type semiconductor and each thermoelectric element 7B is formed of an n-type semiconductor. In other embodiments, the thermoelectric elements 7A, 7B may be formed of metal.

Multiple sets of the elements 7A and 7B are combined with each other to form a subunit 8. The subunit 8 includes two plates 9A, 9B. The thermoelectric elements 7A, 7B are arranged between the two plates 9A, 9B. The plates 9A and 9B are preferably made of a material having high thermal conductivity. The multiple sets of the thermoelectric elements 7A and 7B are arranged in a planar fashion along and between the two plates 9A and 9B. One end on the side of the plate 9A of a thermoelectric element 7A is electrically connected to one end of the same side of an adjoining thermoelectric element 7B via an electrode 13, and the other end on the side of the plate 9B of the thermoelectric element 7B is in turn electrically connected to one end of the same side of another adjoining thermoelectric element 7A via another electrode 13. As a result, the multiple sets of the thermoelectric elements 7A and 7B form a series of electric circuits. The thermoelectric elements 7A and 7B may be connected to one another in any fashion, such as in series, in parallel or the combination thereof. In the present embodiment, a single plate unit 12 includes the multiple sets of the thermoelectric elements 7A and 7B, which are connected in series to one another to form an electric circuit having two electrodes 13 at either end of the circuit. Each electrode 13 is connected to a lead 15.

An insulator 16 is provided such that it extends between each electrode 13 and either of the two plates 9A and 9B, between the two electrodes 13, and between the thermoelectric elements 7A and 7B. Respective edges of the plates 9A, 9B are bonded to each other at either end except for where the leads 15 are drawn out. The plates 9A and 9B may be bonded by pressing bonding or any other bonding method.

The plurality of subunits 8 formed as described above are disposed between two plates 11A and 11B so that the subunits 8 and the plates 11A and 11B form a plate unit 12. Each subunit 8 is arranged such that the plates 9A, 9B are in contact with the plate 11A, 11B, respectively. The subunits 8 are connected one another by the leads 15 to form a series of electric circuits. The subunits 8 may be connected to one another in any fashion such as in series, in parallel or the combination thereof. In the present embodiment, the subunits 8 are connected in series to one another. Respective edges of the plates 11A, 11B are bonded to each other at either end except for where the leads 15 are drawn out from the subunits 8 at the ends of the circuits. The plates 11A and 11B may be bonded by pressing bonding or any other bonding method.

In the present embodiment, the thermoelectric elements 7A and 7B are combined to form each of the subunits 8, and the subunits 8 are disposed between the two plates 11A and 11B. In other embodiments, the plates 9A and 9B may be omitted and the thermoelectric elements 7A and 7B may be disposed between the plates 11A and 11B with the insulator 16 being disposed therebetween.

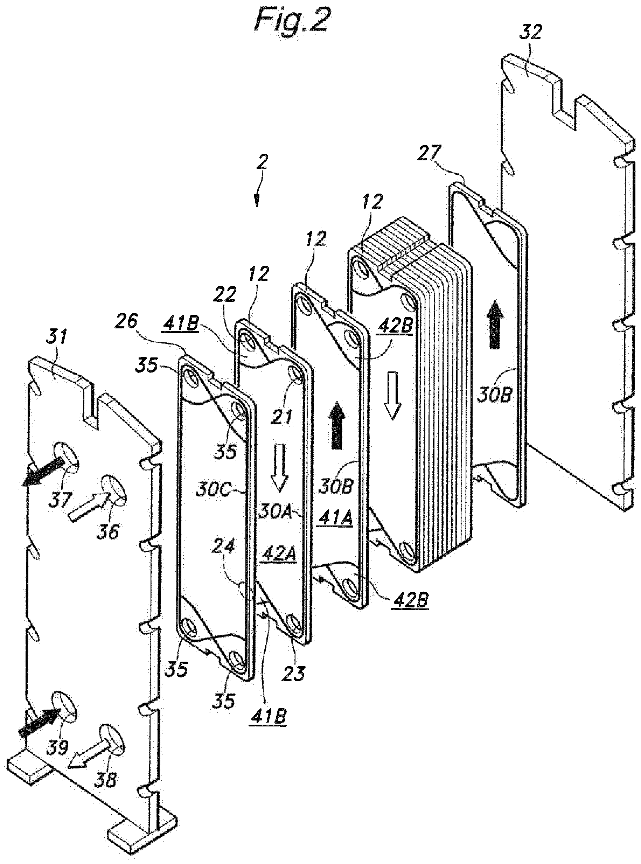

As shown in Figure 2, the bonded upper edges of the two plates 11A and 11B define a first hole 21 and a second hole 22 extending through both the plates 11A and 11B in their thickness direction. Similarly, the bonded lower edges of the two plates 11A and 11B define a third hole 23 and a fourth hole 24 extending through both the plates 11A and 11B in their thickness direction. Since the first to fourth holes 21-24 are formed in the portions where the plates 11A and 11B are bonded to each other, the first to fourth holes 21-24 are separated from the space where the thermoelectric elements 7A and 7B are arranged between the two plates 11A and 11B. In another embodiment, a gasket may be interposed between the plates 11A and 11B so that the space in which the thermoelectric elements 7A and 7B are disposed is liquid-tightly partitioned from the first to fourth holes 21-24.

The power generation module 2 includes a plurality of plate units 12 laminated in a front-to-rear direction, a front end plate 26 disposed on the front side of the frontmost plate unit 12, a rear end plate 27 disposed on the rear side of the rearmost plate unit 12, and gaskets 30A, 30B, 30C disposed between respective adjoining plate units 12 which are arranged between the frontmost plate unit 12 and the front end plate 26, and disposed between the rearmost plate unit 12 and the rear end plate 27. A front outer plate 31 is disposed on the front side of the front end plate 26 and a rear outer plate 32 is disposed on the rear side of the rear end plate 27. The front outer plate 31 and the rear outer plate 32 are connected by a plurality of tie rods (not shown) extending in the front-to-rear direction, and thus the front end plate 26, the plurality of plate units 12, the rear end plate 27, and the gaskets 30A, 30B, 30C are laminated in the front-to-rear direction and sandwiched between the front outer plate 31 and the rear outer plate 32.

The front end plate 26 defines connection hole 35 extending through in the thickness direction and substantially aligned with the first to fourth holes 21-24. The front outer plate 31 defines a high-temperature fluid inlet hole 36, a low-temperature fluid outlet hole 37, a high-temperature fluid outlet hole 38, and a low-temperature fluid inlet hole 39 which are substantially aligned with the first hole 21, the second hole 22, the third hole 23, and the fourth hole 24, respectively. The high-temperature fluid inlet hole 36, the low-temperature fluid outlet hole 37, the high-temperature fluid outlet hole 38, and the low-temperature fluid inlet hole 39 extend through the front outer plate 31 in its thickness direction.

The gaskets 30A, 30B, 30C include three types of gaskets; that is, a first, gasket 30A, a second gasket 30B, and a third gasket 30C. The plate units 12 are numbered as first, second, ...n-th in ascending order from the front side (n is an odd number in the present embodiment). Each first gasket 30A is interposed between the front surface of an odd-numbered plate unit 12 and the rear surface of a corresponding even-numbered plate unit 12 or the rear surface of the front end plate 26. Each second gasket 30B is interposed between the rear surface of an odd-numbered plate unit 12 and the front surface of a corresponding even-numbered plate unit 12 or the front surface of the rear end plate 27. The third gaskets 30C are interposed between the rear surface of the front outer plate 31 and the front surface of the front end plate 26, respectively.

Each first gasket 30A, the rear surface of a corresponding even-numbered plate unit 12, and the front surface of an corresponding odd-numbered plate unit 12 form low-temperature continuous passages 41B connecting the second holes 22 of both the plate units 12 and connecting the fourth holes 24 of both the plate units 12, respectively, and also form high-temperature main passages 42A connecting the first holes 21 of both the plate units 12 and connecting the third holes 23 of both the plate units 12, respectively. Similarly, the first gasket 30A, the rear surface of the front end plate 26, and the front surface of the odd-numbered plate unit 12 form the low-temperature continuous passages 41B connecting the second hole 22 and the connection hole 35 substantially aligned with the second hole 22 and connecting the fourth hole 24 and the connection hole 35 substantially aligned with the fourth hole 24, respectively, and also form the high-temperature main passage 42A connecting all the four holes including the first hole 21, the third hole 23, and the two connections holes 30 substantially aligned with the first hole 21 and the third hole 23, respectively. The high-temperature main passages 42A are formed so as to cover most part of the main surfaces of the plate units 12.

Each second gasket 30B, the rear surface of a corresponding odd-numbered plate unit 12, and the front surfaces of an corresponding even-numbered plate unit 12 form high-temperature connection passages 42B which are one connecting the first holes 21 of the plate units 12 and the other connecting the third holes 23 of both the plate units 12, and also form low-temperature main passages 41A which are one connecting the second holes 22 of both the plate units 12 and the other connecting the fourth holes 24 of both the plate units 12. Also, the second gasket 30B, the rear surface of the odd-numbered plate unit 12, and the front surface of the rear end plate 27 form the low-temperature main passage 41A connecting the second hole 22 and the fourth hole 24, and closes the first hole 21 and the third hole 23. The low-temperature main passages 41A are formed so as to cover most part of the main surfaces of the plate units 12.

The third gasket 30C, the rear surface of the front outer plate 31, and the front end plate 26 form the high-temperature connection passages 42B which are one connecting the high-temperature fluid inlet hole 36 and the connection hole 35 substantially aligned with the hole 36 and the other connecting the high-temperature fluid outlet hole 38 and the connection hole 35 substantially aligned with the hole 38, and also form the low-temperature continuous passages 41B which are one connecting the low-temperature fluid inlet hole 39 and the connection hole 35 substantially aligned with the hole 39 and the other connecting the low-temperature fluid outlet hole 37 and the connection hole 35 substantially aligned with the hole 37.

With the above-described configuration, the high-temperature fluid inlet hole 36 and the high-temperature fluid outlet hole 38 are connected to each other via the high-temperature connection passage 42B, the first hole 21, the high-temperature main passage 42A, and the third hole 23 to form part of the high-temperature fluid passage 4. Likewise, the low-temperature fluid inlet hole 39 and the low-temperature fluid outlet hole 37 are connected to each other via the low-temperature connection passage 41B, the fourth hole 24, the low-temperature main passage 41A, and the second hole 22 to form part of the low-temperature fluid passage 5. The high-temperature fluid passage 4 and the low-temperature fluid passage 5 are disposed on either of the front and rear surfaces of each plate unit 12. The high-temperature fluid flowing through the high-temperature fluid passage 4 flows downward on one surface of the plate unit 12 (see voided arrows in Figure 2), and the low-temperature fluid flowing through the low-temperature fluid passage 5 flows upward on the other surface of the plate unit 12 (see black arrows in Figure 2). Thus, the high-temperature fluid and the low-temperature fluid flow in opposite directions along opposite sides of the plate unit 12.

The heat exchanger 3 has a passage through which the high-temperature fluid flows and another passage through which the low-temperature fluid flows, and exchanges heat between the high-temperature fluid and the low-temperature fluid. The heat exchanger 3 may be a known heat exchanger 3 such as a plate-type heat exchanger or a spiral-type heat exchanger. The passage for the high-temperature fluid and the passage for the low-temperature fluid are arranged such that the high-temperature fluid and the low-temperature fluid flow in opposite directions.

In the power generation module 2, the high-temperature fluid inlet hole 36, the high-temperature fluid outlet hole 38, the low-temperature fluid inlet hole 39, and the low-temperature fluid outlet hole 37 are connected to the passage 4C, the passage 4D, the passage 5C, and the passage 5D, respectively.

A flow rate adjusting valve 50 is provided in the bypass passage 5F. By opening and closing the flow rate adjusting valve 50, the flow rate of the low-temperature fluid flowing through the bypass passage 5F is adjusted. Thus, by opening and closing the flow rate adjusting valve 50, the flow rate of the low-temperature fluid flowing into the power generation module 2 is adjusted.

A high-temperature-side temperature sensor 51 is provided in the passage 4D of the high-temperature fluid passage 4 at the outlet of the power generation module 2, and a low-temperature-side temperature sensor 52 is provided in the passage 5D of the low-temperature fluid passage 5 at the outlet of the power generation module 2. The low-temperature-side temperature sensor 52 is provided in the passage 5D upstream from where the downstream end of the bypass passage 5F is connected to the passage 5D. Furthermore, the power generation system 1 has a control device (not shown) for controlling the flow rate adjusting valve 50. The control device receives detection signals from the high-temperature-side temperature sensor 51 and the low-temperature-side temperature sensor 52 and calculates, on the basis of these detection signals, a temperature difference ΔT between the high-temperature fluid and the low-temperature fluid at the outlets of the power generation module 2. Then, the control device sets the target opening degree of the flow rate adjusting valve 50 based on the calculated temperature difference ΔT, and controls the degree of opening/closing of the flow rate adjusting valve 50. For example, when the temperature difference ΔT is equal to or greater than the prescribed threshold value, the control device 53 closes the flow rate adjusting valve 50, and when the temperature difference ΔT is less than the threshold value, the control device 53 controls the low-rate-adjusting valve 50 so that the degree of opening increases as the temperature difference ΔT decreases.

In the power generation module 2, when the high-temperature fluid flows on one surface of the plate unit 12 and the low-temperature fluid flows on the other surface of the plate unit 12, the temperatures of one ends of the thermoelectric elements 7A and 7B on the side of the one surface of the plate unit 12 become higher than those of the other ends of the thermoelectric elements 7A and 7B on the other side, by which temperature differences occur between the respective ends of the thermoelectric elements 7A and 7B. As a result, an electromotive force is generated in each of the thermoelectric elements 7A and 7B due to the Seebeck effect. The electromotive forces generated in the thermoelectric elements 7A and 7B are proportional to the temperature differences occurring in the thermoelectric elements 7A and 7B, respectively.

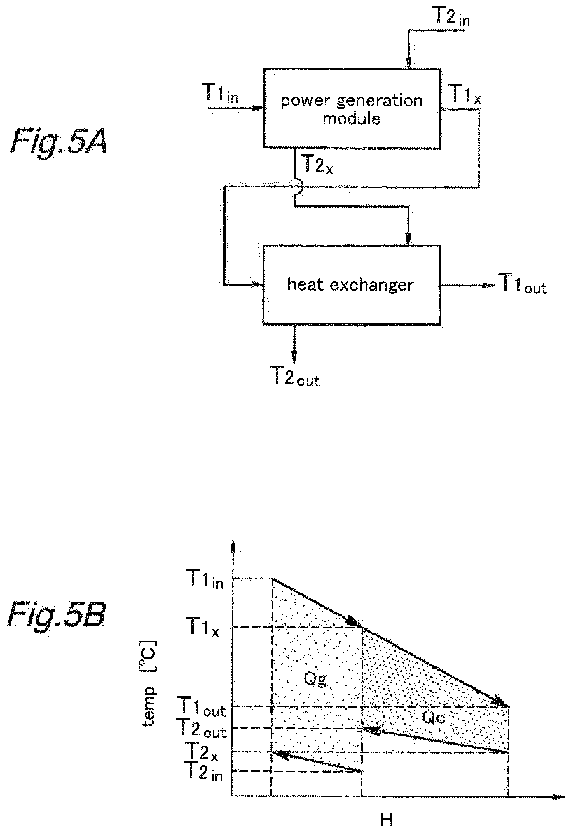

In the power generation system 1 shown in Figure 5, T1in denotes a temperature of the high-temperature fluid measured at the inlet of the system 1 (or the high-temperature fluid inlet hole 36), T1x denotes a temperature of the high-temperature fluid measured at the outlet of the power generation module 2 (or the high-temperature fluid outlet hole 38, the inlet of the heat exchanger 3), T1out denotes a temperature of the high-temperature fluid measured at the outlet of the system 1 (or the outlet of the heat exchanger 3), T2in denotes a temperature of the low-temperature fluid measured at the inlet (or the low-temperature fluid inlet hole 39) of the power generation system 1, T2x denotes a temperature of the low-temperature fluid measured at the outlet of the power generation module 2 (or the low-temperature fluid outlet hole 37, the inlet of the heat exchanger 3), and T2 denotes a temperature of the low-temperature fluid measured at the outlet of the system 1 (or the outlet of the heat exchanger 3).

The temperature difference ΔT (ΔT = T1x - T2x) between the high-temperature fluid and the low-temperature fluid at the outlet of the power generation module 2 is set to be not less than a prescribed level. The temperature difference ΔT is set to 30-degrees Celsius or more, preferably 50-degrees Celsius or more. The temperature difference ΔT can be varied by changing the temperatures and/or flow rates of the high-temperature fluid and the low-temperature fluid.

In the power generation system 1, the amount of heat loss from the high-temperature fluid occurring during flow of the fluid in the power generation module 2 is indicated by Qg, the amount of heat loss from the high-temperature fluid occurring during flow of the fluid in the heat exchanger 3 is indicated by Qc, and the amount of heat loss from the high-temperature fluid occurring during flow of the fluid in the entire system is represented by Q0 (= Qg + Qc). The amount of heat loss (Qg) from the high-temperature fluid occurring in the power generation module 2 is the total sum of the amount of heat received by the low-temperature fluid by heat transfer (Q1), the amount of heat applied to the thermoelectric elements 7A, 7B by thermal conduction and converted to electricity (Q2), Joule heat generated by current flowing through the thermoelectric elements 7A and 7B (Q3), and the amount of heat dissipated from the power generation module 2 (Q4). The amount of heat (Q5) which causes the temperature rise of the low-temperature fluid is the total sum of the amount of heat transferred to the low-temperature fluid by heat conduction (Q1) and the Joule heat (Q3). The amount of heat Q5 (= Q1 + Q3) received by the low-temperature fluid can be obtained by measuring the inlet temperature T2in and the outlet temperature T2x of the low-temperature fluid of the power generation module 2. In the present embodiment, the power generation efficiency η (%) in the power generation module 2 is defined as η = Q2 / (Q5 + Q2) with reference to the amount of heat Q5 received by the low-temperature fluid.

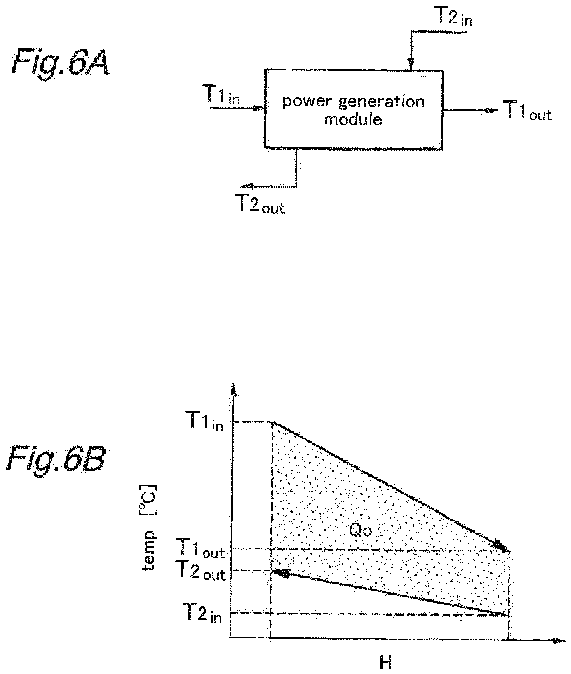

Figure 6 shows a power generation system 1, in which the heat exchanger 3 is omitted and only the power generation module 2 is used, as a comparative embodiment to be compared with the power generation system 1 according to the present embodiment. In the power generation system 1 of the comparative embodiment, the temperatures of the high- and the low-temperature fluids measured at their inlets and the temperatures of the high- and the low-temperature fluids measured at their outlets are set to the same values as the temperatures T1in, T2in, T1out, T2out of the power generation system 1 of the present embodiment. In the power generation system 1 of the comparative embodiment, the temperature difference ΔT2 (T1out - T2out) between the high-temperature fluid and the low-temperature fluid at the outlets of the power generation module 2 is obtained. Since the temperature difference ΔT at the outlets of the power generation module 2 in the power generation system 1 according to the present embodiment is larger than the temperature difference ΔT2 at the outlet of the power generation module 2 according to the comparative embodiment, the amount of power generation per one thermoelectric element 7A, 7B increases. In addition, the temperature T2x of the low-temperature fluid at the outlet of the power generation module 2 of the present embodiment is lower than the temperature T2out of the low-temperature fluid at the outlet of the power generation module 2 of the comparative embodiment and the amount of heat Q5 received by the low-temperature fluid in the present embodiment is smaller than that in the comparative embodiment, which means that the power generation efficiency of the power generation system 1 according to the present embodiment is improved as compared with the comparative embodiment.

Since the power generation system 1 according to the first embodiment includes the heat exchanger 3 located downstream of the power generation module 2, the system is allowed to lower the temperature of the high-temperature fluid at the outlet of the power generation system 1 to a prescribed level or less while maintaining a large temperature difference between the high-temperature fluid and the low-temperature fluid in the power generation module 2. As a result, the power generation system 1 of the present embodiment can be substituted for a heat exchanger 3 located in a place where otherwise only the heat exchanger 3 is used in a plant or other facilities of the prior art. Also, the power generation system 1 of the present embodiment can be formed by adding a thermoelectric module to a location upstream from where only the heat exchanger 3 is used in a plant or other facilities of the prior art.

Since the system controls the flow rate adjusting valve 50 based on the temperature difference ΔT between the high-temperature fluid and the low-temperature fluid at the outlets of the power generation module 2 to thereby control the flow rate of the low-temperature fluid passing through the power generation module 2, the temperature difference ΔT between the high-temperature fluid and the low-temperature fluid at the outlets of the power generation module 2 is maintained at a prescribed threshold level or more, which enables the thermoelectric elements 7A and 7B to generate power with high efficiency. As a result, even when changes occur in the temperatures and flow rates of the high-temperature fluid and the low-temperature fluid flowing into the power generation system 1, the power generation module 2 can generate power with high efficiency.

Power generation systems according to the second to seventh embodiments of the present invention will be described below. The power generation systems of the second to seventh embodiments are different from the power generation system 1 of the first embodiment in configurations of the high-temperature fluid passage and the low-temperature fluid passage. In the power generation systems of the second to seventh embodiments, the same or similar parts as in the first embodiment are designated by the same or similar references and the descriptions of those parts will not be repeated.

### (Second Embodiment)

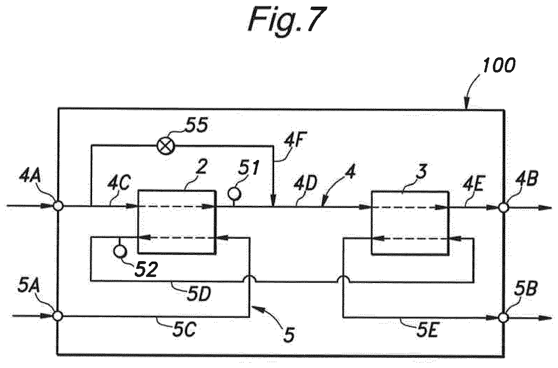

As shown in Figure 7, a power generation system 100 according to the second embodiment is different from the power generation system 1 according to the first embodiment in that, in the system 100, the high-temperature fluid passage 4 has a bypass passage 4F connected to the passage 4C and to the passage 4D to bypass the power generation module 2. The power generation system 100 is also different from the power generation system 1 in that, in the system 100, the low-temperature fluid passage 5 of the power generation system 100 is not provided with the bypass passage 5F and the flow rate adjusting valve 50.

A flow rate adjusting valve 55 is provided in the bypass passage 4F. By opening and closing the flow rate adjusting valve 55, the flow rate of the high-temperature fluid flowing through the bypass passage 4F is adjusted. Thus, by opening and closing the flow rate adjusting valve 55, the flow rate of the high-temperature fluid flowing into the power generation module 2 is adjusted. The control device controls the flow rate adjusting valve 55 based on the temperature difference ΔT between the high-temperature fluid and the low-temperature fluid at the outlets of the power generation module 2.

In the power generation system 100, even when changes occur in the temperatures and the flow rates of the high-temperature fluid and the low-temperature fluid flowing into the power generation system 100, the flow rate of the high-temperature fluid supplied to the power generation module 2 can be controlled by the flow rate adjusting valve 55. As a result, the temperature difference ΔT between the high-temperature fluid and the low-temperature fluid at the outlets of the power generation module 2 is maintained at around a prescribed level, thereby enabling the power generation module 2 to generate power with high efficiency.

### (Third Embodiment)

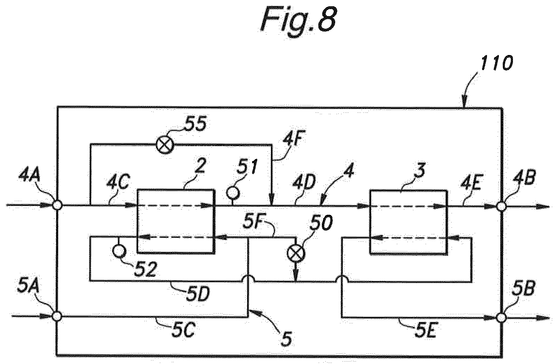

As shown in Figure 8, a power generation system 110 according to the third embodiment is different from the power generation system 1 according to the first embodiment in that, in the system 110, the high-temperature fluid passage 4 has a bypass passage 4F connected to the passage 4C and to the passage 4D to bypass the power generation module 2. A flow rate adjusting valve 55 is provided in the bypass passage 4F. The control device controls the flow rate adjusting valve 50 based on the temperature difference ΔT between the high-temperature fluid and the low-temperature fluid at the outlets of the power generation module 2.

In power generation system 110, even when changes occur in the temperatures and the flow rates of the high-temperature fluid and the low-temperature fluid flowing into the power generation system 110, the flow rates of the high-temperature fluid and the low-temperature fluid supplied to the power generation module 2 can be controlled by the flow rate adjusting valves 50, 55.

### (Fourth Embodiment)

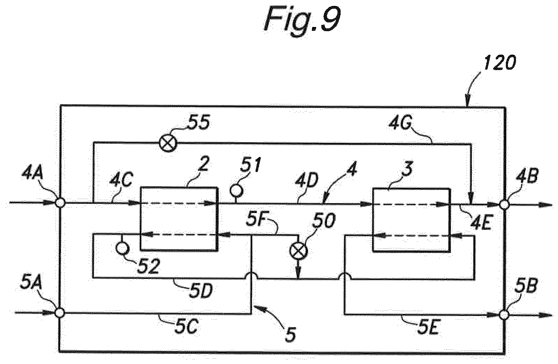

As shown in Figure 9, a power generation system 120 according to the fourth embodiment is different from the power generation system 1 according to the first embodiment in that, in the system 120, the high-temperature fluid passage 4 has a bypass passage 4G connected to the passage 4C and to the passage 4D to bypass the power generation module 2 and the heat exchanger 3. A flow rate adjusting valve 55 is provided in the bypass passage 4G. By opening and closing the flow rate adjusting valve 55, the flow rate of the high-temperature fluid flowing through the bypass passage 4F is adjusted. The control device controls the flow rate adjusting valve 55 based on the temperature difference ΔT between the high-temperature fluid and the low-temperature fluid at the outlets of the power generation module 2.

### (Fifth Embodiment)

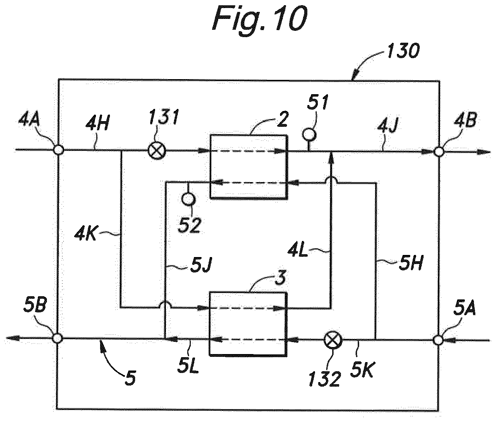

As shown in Figure 10, a power generation system 130 according to the fifth embodiment is different from the power generation system 1 according to the first embodiment in that, in the system 130, each of the high-temperature fluid passage 4 and the low-temperature fluid passage 5 connects the power generation module 2 and the heat exchanger 3 in parallel. The high-temperature fluid passage 4 includes a passage 4H connecting the high-temperature fluid inlet 4A and the power generation module 2, a passage 4J connecting the power generation module 2 and the high-temperature fluid outlet 4B, a passage 4K connecting the passage 4H and the heat exchanger 3, and a passage 4L connecting the heat exchanger 3 and the passage 4J. The passage 4K, the heat exchanger 3, and the passage 4L form a series of bypass passages to bypass the power generation module 2. A flow rate adjusting valve 131 is provided in the passage 4H downstream (on the side of the power generation module 2) from where the passage 4K is connected to the passage H. A high-temperature-side temperature sensor 51 is provided in the passage 4J upstream (on the side of the power generation module 2) from where the passage 4L is connected to the passage 4J.

The low-temperature fluid passage 5 includes a passage 5H connecting the low-temperature fluid inlet 5A and the power generation module 2, a passage 5J connecting the power generation module 2 and the low-temperature fluid outlet 5B, a passage 5K connecting the passage 5H and the heat exchanger 3, and a passage 5L connecting the heat exchanger 3 and the passage 5J. The passage 5K, the heat exchanger 3, and the passage 5L form a series of bypass passages to bypass the power generation module 2. A flow rate adjusting valve 132 is provided in the passage 5K. A low-temperature-side temperature sensor 51 is provided in the passage 5J upstream (on the side of the power generation module 2) from where the passage 5L is connected to the passage 5J. The control device controls the flow rate adjusting valves 131 and 132 based on the temperature difference ΔT between the high-temperature fluid and the low-temperature fluid at the outlets of the power generation module 2.

### (Sixth Embodiment)

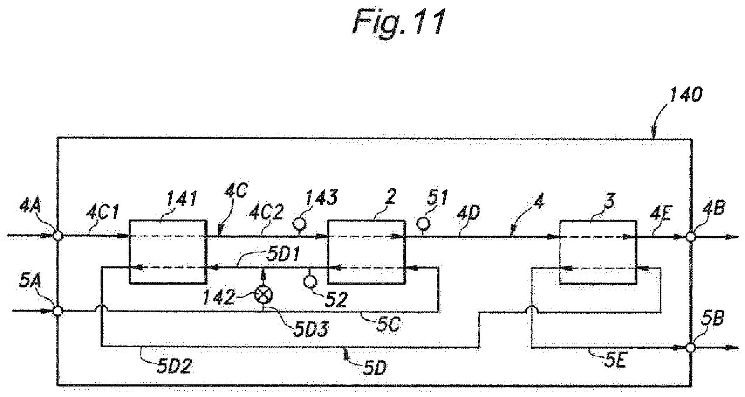

As shown in Figure 11, a power generation system 140 according to the sixth embodiment is different from the power generation system 1 according to the first embodiment in that, in the system 140, the high-temperature fluid passage 4 has the passage 4C in which a temperature controller 141 is provided. The temperature controller 141 is an apparatus for adjusting the high-temperature fluid supplied to the power generation system 140 to a temperature suitable for the power generation module 2. In the sixth embodiment, the temperature controller 141 is a known countercurrent type heat exchanger, which exchanges heat between the high-temperature fluid supplied to the high-temperature fluid inlet 4A and the low-temperature fluid supplied to the low-temperature fluid inlet 5A without mixing the high-temperature fluid and the low-temperature fluid.

The temperature controller 141 is connected to the high-temperature fluid inlet 4A via a passage 4C1, a part of the passage 4C on the upstream side of the controller 141, and connected to the power generation module 2 via a passage 4C2, a part of the passage 4C on the downstream side of the controller 141. Moreover, the temperature controller 141 is connected to the power generation module 2 via a passage 5D1, a part of the passage 5D on the upstream side of the controller 141, and connected to the heat exchanger 3 via a passage 5D2, a part of the passage 5D on the downstream side of the controller 141. The passage 5C and the passage 5D1 are connected to each other via a bypass passage 5D3 for bypassing the power generation module 2. A flow rate adjusting valve 142 is provided in the bypass passage 5D3 for changing the flow rate of the low-temperature fluid flowing into the power generation module 2.

An inlet temperature sensor 143 is provided in the passage 4C2 at the inlet of the power generation module 2 for detecting the temperature of the high-temperature fluid flowing into the power generation module 2. The control device of the power generation system 140 controls the flow rate adjusting valve 142 based on the detected signal from the inlet temperature sensor 143. For example, when the temperature of the high-temperature fluid flowing into the power generation module 2 is equal to or higher than a prescribed level, the control device opens the flow rate adjusting valve 142, and increases the opening degree as the temperature rises.

The thermoelectric elements 7A and 7B of the power generation module 2 may be deformed or damaged when exposed to an excessively high temperature exceeding their use temperature range. However, in the power generation system 140, the temperature controller 141 controls the temperature of the high-temperature fluid flowing into the power generation module 2 to ensure that damage to the thermoelectric elements 7A, 7B is prevented. The temperature controller 141 for cooling the high-temperature fluid is applied to cases where the high-temperature fluid is steam or high temperature steam of thermal oil, hydrocarbon, or the like.

### (Seventh Embodiment)

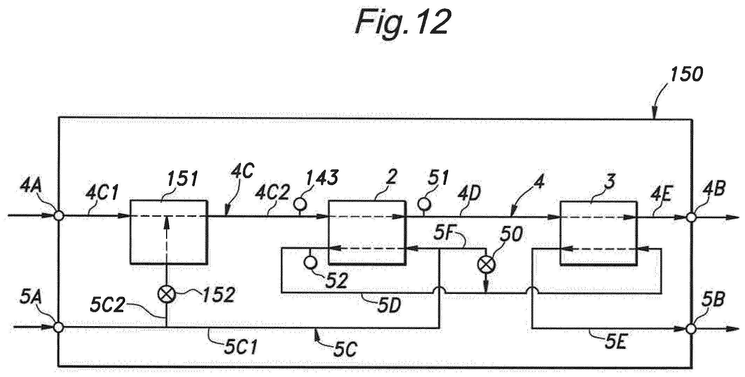

As shown in Figure 12, a power generation system 150 according to the seventh embodiment is different from the power generation system 140 according to the sixth embodiment in the configurations of a temperature controller 151 and a passage 5C. The passage 5C includes a passage 5C1 connecting the low-temperature fluid inlet 5A and the power generation module 2 and a passage 5C2 connecting the passage 5C1 and the temperature controller 151. A flow rate adjusting valve 152 is provided in the passage 5C2 for changing the flow rate of the low-temperature fluid flowing into the temperature controller 151. The temperature controller 151 cools the high-temperature fluid by mixing the low-temperature fluid supplied from the passage 5C2 and the high-temperature fluid flowing from the passage 4C1 to the passage 4C2. The control device of the power generation system 150 controls the flow rate adjusting valve 152 based on the detection signal from the inlet temperature sensor 143. The seventh embodiment can be applied to cases where a high-temperature fluid and a low-temperature fluid can be mixed, e.g. when the high-temperature fluid is steam and the low-temperature fluid is water.

Example applications of the power generation systems of the first to seventh embodiments to various types of plants will be described below. Although the power generation system 1 according to the first embodiment is used in the following examples, the power generation systems 100, 110, 120, 130, 140, and 150 according to the second to seventh embodiments can be used in a similar manner.

### (Example Application to Petroleum Refining Plant)

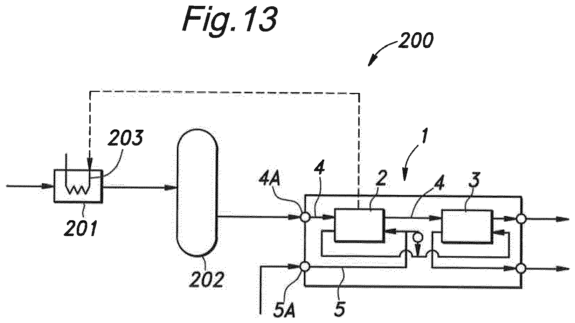

As shown in Figure 13, a petroleum refining plant 200 includes a heating furnace 201 for heating crude oil and a distillation unit 202 (distillation column) for distilling the crude oil heated in the heating furnace 201. The power generation system 1 is provided downstream of the distillation unit 202 and is used as a heat exchanger for cooling any component of crude oil (e.g. heavy oil, light oil, kerosene, gasoline, or other component) separated in the distillation unit 202. The high-temperature fluid inlet 4A of the power generation system 1 is connected to a passage in which the component distilled in the distillation unit 202 flows, and the low-temperature fluid inlet 5A of the power generation system 1 is connected to a cooling water passage. The component separated from crude oil in the distillation unit 202 is cooled during passing through the power generation system 1, and the power generation system 1 utilizes part of heat of the component to generate power.

The low-temperature fluid inlet 5A of the power generation system 1 may be connected to a passage in which crude oil flows before being fed to the heating furnace 201, instead of being connected to the cooling water passage. In this case, crude oil is heated using heat obtained from a component which has flown through the distillation unit 202 in the power generation system 1, which improves the energy efficiency in the petroleum refining plant 200.

A heating unit 203 for providing heat by using electric power is provided in the heating furnace 201 or passage in which crude oil flows, and electric power generated by the power generation system 1 is supplied to the heating unit 203. The heating unit 203 may be, for example, a heating device utilizing resistive heating. In this case, energy efficiency in the petroleum refining plant 200 is improved. In another embodiment, the heating unit 203 may be a heat exchanger, a heater for providing heat by fuel burning or the like, instead of using the heating device for providing heat by using electric power.

### (Example Application to Power Generating Plant)

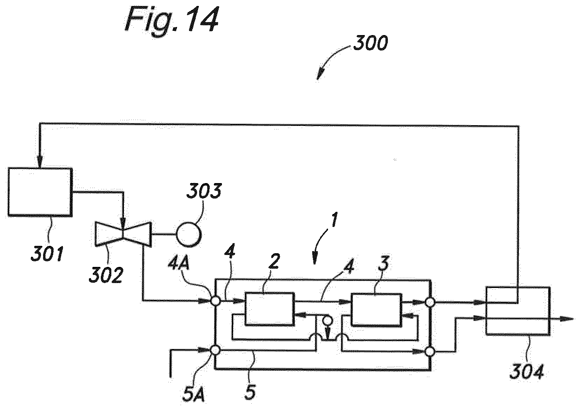

As shown in Figure 14, a power generating plant 300 includes a boiler 301 for heating water to generate steam, a steam turbine 302 driven by steam generated by the boiler 301, a generator 303 driven by the steam turbine 302, and a condenser 304 for cooling and condensing the steam which has passed through the steam turbine 302. The power generation system 1 of the present embodiment is provided between the steam turbine 302 and the condenser 304 and is used as a heat exchanger for cooling steam. The high-temperature fluid inlet 4A of the power generation system 1 is connected to a passage in which the steam having passed through the steam turbine 302 flows and the low-temperature fluid inlet 5A of the power generation system 1 is connected to a cooling water passage common to the condenser 304. This means that the steam that has passed through the steam turbine 302 is used as the high-temperature fluid, and the cooling water used for the condenser 304 is used as the low-temperature fluid. The cooling water may be seawater, for example. The steam that has passed through the steam turbine 302 is cooled during passing through the power generation system 1, and the power generation system 1 utilizes part of the heat of the steam to generate electric power. The power generation system generates power using the heat of steam otherwise discarded in the condenser 304, which improves the energy efficiency of the power generating plant 300.

### (Example Application to LNG Regasification Facility)

As shown in Figure 14, an LNG regasification facility 400 includes an LNG tank 401 for storing LNG and a seawater type vaporizer 402 for vaporizing LNG. The seawater type vaporizer 402 exchanges heat between seawater and LNG to vaporize the LNG by using the heat of the seawater. The power generation system 1 according to the present embodiment is provided between the LNG tank 401 and the seawater type vaporizer 402 and is used as the heat exchanger 3 that increases the temperature of the LNG. The high-temperature fluid inlet 4A of the power generation system 1 is connected to a seawater passage, which is also connected to the seawater type vaporizer 402, and the low-temperature fluid inlet 5A of the power generation system 1 is connected to a passage in which the LNG from the LNG tank 401 flows. This means that the seawater is used as the high-temperature fluid, and the LNG is used as the low-temperature fluid. The LNG is heated during passing through the power generation system 1, and the power generation system 1 utilizes a temperature difference between the seawater and the LNG to generate electric power.

### (Example Application to Reaction Facility)

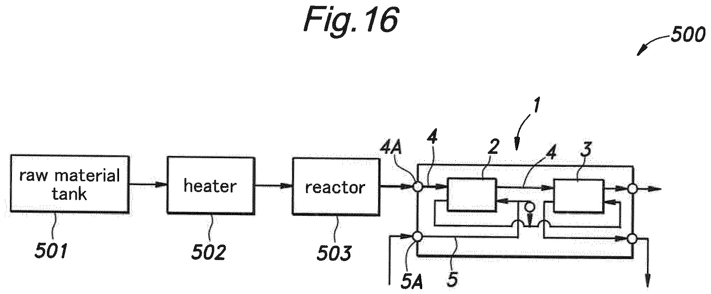

As shown in Figure 16, a reaction facility 500 is a facility for reacting various materials to produce a product. The reaction facility 500 includes a raw material tank 501, a heater 502, and a reactor 503. The power generation system 1 can be applied to various chemical industrial plants utilizing such a reaction facility 500 including plants for the petrochemical industry, the natural gas chemical industry, the coal chemical industry, the polymer chemical industry and other industries.

The raw material tank 501 is a tank for storing a raw material. The heater 502 heats the raw materials fed from the raw material tank 501 to the reactor 503. The heater 502 is an electric heater, a heat exchanger, or any other type of heater. The reactor 503 is a vessel for causing an exothermic reaction or an endothermic reaction.

The power generation system 1 according to the present embodiment is provided downstream of the reactor 503 and is used as a heat exchanger for cooling the product generated in the reactor 503. The high-temperature fluid inlet 4A and the low-temperature fluid inlet 5A of the power generation system 1 are connected to an outlet of the reactor 503 and a cooling water passage, respectively. The product is cooled during passing through the power generation system 1. The power generation system 1 utilizes a temperature difference between the product and the cooling water to generate power. For example, when the heater 502 is an electric heater, the electric power generated by the power generation system 1 is supplied to the heater 502 and used to heat the raw material.

### (Example Application to Dehydrogenation Reaction Facility)

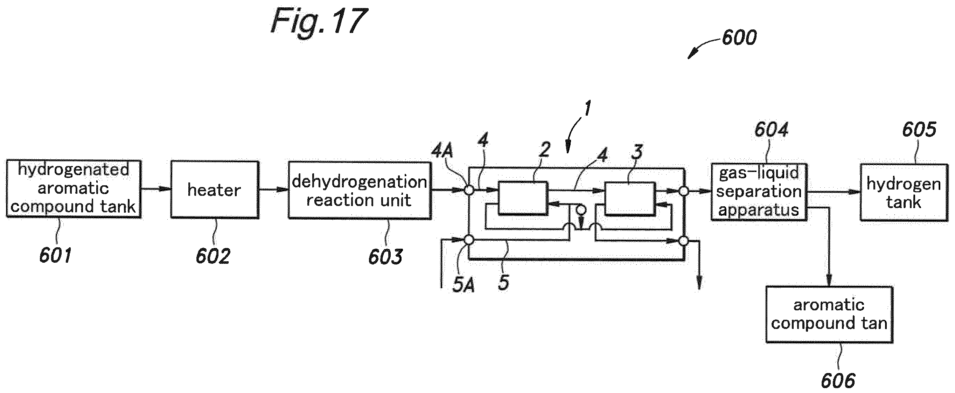

As shown in Figure 17, a dehydrogenation reaction facility 600 is a facility for producing hydrogen and an aromatic compound from a hydrogenated aromatic compound. Non-limiting examples of the hydrogenated aromatic compounds include benzene, toluene, and naphthalene, and non-limiting examples of the aromatic compounds include cyclohexane, methylcyclohexane, and tetralin. The dehydrogenation reaction facility 600 includes a hydrogenated aromatic compound tank 601, a heater 602, a dehydrogenation reaction unit 603, a gas-liquid separation apparatus 604, a hydrogen tank 605, and an aromatic compound tank 606.

The hydrogenated aromatic compound tank 601 is a tank for storing a hydrogenated aromatic compound as a raw material. The heater 602 heats the hydrogenated aromatic compound fed from the hydrogenated aromatic compound tank 601 to the dehydrogenation reaction unit 603. The heater 602 is an electric heater, a heat exchanger, or any other type of heater. The dehydrogenation reaction unit 603 is a reaction vessel filled with a dehydrogenation catalyst for separating the hydrogenated aromatic compound into hydrogen and an aromatic compound. The hydrogenated aromatic compound heated by the heater 602 is decomposed in the dehydrogenation reaction unit 603 and fed to a gas-liquid separation apparatus 604 as a mixture of the hydrogen and the aromatic compound. The gas-liquid separation apparatus 604 separates the mixture to the hydrogen in the gaseous form and the aromatic compound in the liquid form. The hydrogen separated by the gas-liquid separation apparatus 604 is stored in a hydrogen tank 605, and the aromatic compound is stored in an aromatic compound tank 606.

The power generation system 1 according to the present embodiment is provided between the dehydrogenation reaction unit 603 and the gas-liquid separation apparatus 604 and used as a heat exchanger for cooling the hydrogen and the aromatic compound generated in the dehydrogenation reaction unit 603. The high-temperature fluid inlet 4A and the low-temperature fluid inlet 5A of the power generation system 1 are connected to an outlet of the dehydrogenation reaction unit 603 and a cooling water passage, respectively. The hydrogen and the aromatic compound are cooled during passing through the power generation system 1, and the gaseous aromatic compound is condensed. The power generation system 1 utilizes a temperature difference between the mixture of the hydrogen and the aromatic compound and cooling water to generate electric power. For example, when the heater 602 is an electric heater, the electric power generated by the power generation system 1 is supplied to the heater 602 and used to heat the hydrogenated aromatic compound.

Although the specific embodiments have been described above, the present invention is not limited to the above-described embodiments and can be modified in various ways. For example, although in the above-described embodiments, the control device controls the flow rate adjusting valves (50, 60, etc.) based on the temperature difference ΔT between the high-temperature fluid and the low-temperature fluid at the outlets of the power generation module 2, the temperature of the low-temperature fluid at the outlet of the power generation module 2 may be further controlled to be 60-degrees Celsius or less. In this case, the system can prevent an undesirable rise in the temperature of the fluid in the low-temperature fluid passage 5, thereby minimizing the growth of algae.

### GLOSSARY

- 1, 100, 110, 120, 130, 140, 150: power generation system
- 2: power generation module
- 3: heat exchanger
- 4: high-temperature fluid passage
- 4A: high-temperature fluid inlet
- 4B: high-temperature fluid outlet
- 4F, 4G: bypass passage
- 5: low-temperature fluid passage
- 5A: low-temperature fluid inlet
- 5B: low-temperature fluid outlet
- 5F: bypass passage
- 7A: thermoelectric element
- 7B: thermoelectric element
- 11: plate
- 12: plate unit
- 13: electrode
- 15: lead
- 16: insulator
- 30: gasket
- 50, 55, 142, 152: flow rate adjusting valve
- 51: high-temperature-side temperature sensor
- 52: low-temperature-side temperature sensor
- 141, 151: temperature controller
- 143: inlet temperature sensor
- 200: petroleum refining plant
- 201: heating furnace
- 202: distilling unit
- 203: heating unit
- 300: power generating plant
- 301: boiler
- 302: steam turbine
- 303: power generator
- 304: condenser
- 400: regasification facility
- 401: LNGtank
- 402: seawater type vaporizer
- 501: raw material tank
- 502: heater
- 503: reactor
- 600: dehydrogenation reaction facility
- 601: hydrogenated aromatic compound tank
- 602: heater
- 603: dehydrogenation reaction unit
- 604: gas-liquid separation apparatus
- 605: hydrogen tank
- 606: aromatic compound tank

## Claims

1. A power generation system, comprising:
a power generation module provided with one or more thermoelectric elements;
a heat exchanger;
a high-temperature fluid passage including a high-temperature fluid inlet and a high-temperature fluid outlet, the high-temperature fluid passage being connected to the power generation module and the heat exchanger both located between the high-temperature fluid inlet and the high-temperature fluid outlet; and
a low-temperature fluid passage including a low-temperature fluid inlet and a low-temperature fluid outlet, the low-temperature fluid passage being connected to the power generation module and the heat exchanger both located between the low-temperature fluid inlet and the low-temperature fluid outlet;
wherein the low-temperature fluid passage includes a low-temperature-side bypass passage for bypassing the power generation module, and a low-temperature-side flow rate adjusting valve for adjusting a flow rate of the low-temperature fluid flowing into the power generation module; and
wherein a degree of opening of the low-temperature-side flow rate adjusting valve is controlled based on a temperature difference between the high-temperature fluid and the low-temperature fluid immediate after flowing out of the high-temperature fluid outlet and the low-temperature fluid outlet.

2. The power generation system according to claim 1, wherein the high-temperature fluid passage includes a high-temperature-side bypass passage for bypassing the power generation module, and a high-temperature-side flow rate adjusting valve for adjusting a flow rate of the high-temperature fluid flowing into the power generation module,
wherein a degree of opening of the high-temperature-side flow rate adjusting valve is controlled by the temperature difference between the high-temperature fluid and the low-temperature fluid immediate after flowing out of the high-temperature fluid outlet and the low-temperature fluid outlet.

3. A power generation system comprising:
a power generation module provided with one or more thermoelectric elements;
a heat exchanger;
a high-temperature fluid passage including a high-temperature fluid inlet and a high-temperature fluid outlet, the high-temperature fluid passage being connected to the power generation module and the heat exchanger both located between the high-temperature fluid inlet and the high-temperature fluid outlet;
a low-temperature fluid passage including a low-temperature fluid inlet and a low-temperature fluid outlet, the low-temperature fluid passage being connected to the power generation module and the heat exchanger both located between the low-temperature fluid inlet and the low-temperature fluid outlet;
wherein the high-temperature fluid passage includes a high-temperature-side bypass passage for bypassing the power generation module, and a high-temperature-side flow rate adjusting valve for adjusting a flow rate of the low-temperature fluid flowing into the power generation module; and
wherein a degree of opening of the high-temperature-side flow rate adjusting valve is controlled based on a temperature difference between the high-temperature fluid and the low-temperature fluid immediate after flowing out of the high-temperature fluid outlet and the low-temperature fluid outlet.

4. The power generation system according to claim 2 or 3, wherein the high-temperature-side bypass passage bypasses the power generation module and the heat exchanger.

5. The power generation system according to any one of claims 1 to 4, further comprising a temperature controller provided between the high-temperature fluid inlet and the power generation module for controlling a temperature of the high-temperature fluid.

6. The power generation system according to claim 5, wherein the temperature controller is connected to a branch passage branched from the low-temperature fluid passage, the temperature controller being configured to control the temperature of the high-temperature fluid by mixing the low-temperature fluid supplied from the branch passage and the high-temperature fluid.

7. The power generation system according to claim 5, wherein the temperature controller is connected to a branch passage branched from the low-temperature fluid passage, the temperature controller being configured to control the temperature of the high-temperature fluid by exchanging heat between the low-temperature fluid supplied from the branch passage and the high-temperature fluid without mixing the low-temperature fluid and the high-temperature fluid.

8. The power generation system according to any one of claims 1 to 7, wherein the temperature of the low-temperature fluid is 60-degrees Celsius or lower at the low-temperature fluid outlet.

9. The power generation system according to any one of claims 1 to 8, wherein the power generation module is configured such that the high-temperature fluid and the low-temperature fluid flow in opposite directions along opposite sides of each thermoelectric element.
